# EUROPÄISCHE PATENTSCHRIFT

(11) **EP 2 737 330 B1**
(45) Veröffentlichungstag und Bekanntmachung des Hinweises auf die Patenterteilung: **21.07.2021**
(21) Anmeldenummer: 12748177.8
(22) Anmeldetag: 26.07.2012
(51) Int. Cl.: G01R 31/12, H02H 3/00, G01R 35/00, G01R 31/327

(54) **VERFAHREN ZUR ADAPTION EINES LICHTBOGENSENSORS**
METHOD FOR ADAPTING AN ARC SENSOR
PROCÉDÉ D'ADAPTATION D'UN CAPTEUR D'ARC ÉLECTRIQUE

(30) Priorität: 26.07.2011 AT 10942011; 26.07.2011 US 201161511696 P
(43) Veröffentlichungstag der Anmeldung: 04.06.2014
(73) Patentinhaber: Eaton Intelligent Power Limited, Dublin 4 (IE)
(72) Erfinder: KOCH, Michael, A-1190 Wien (AT)
(74) Vertreter: Eaton IP Group EMEA
(86) Internationale Anmeldenummer: PCT/EP2012/064733
(87) Internationale Veröffentlichungsnummer: WO 2013/014249

(56) Entgegenhaltungen:
- EP-A2- 1 439 396
- WO-A1-01/18554
- WO-A2-98/35237
- DE-A1- 19 758 085
- US-A1- 2008 084 215
- US-A1- 2010 241 372
- HAO L ET AL: "Partial discharge source discrimination using a support vector machine", IEEE TRANSACTIONS ON DIELECTRICS AND ELECTRICAL INSULATION, IEEE SERVICE CENTER, PISCATAWAY, NJ, US, Bd. 17, Nr. 1, 1. Februar 2010 (2010-02-01), Seiten 189-197, XP011302823, ISSN: 1070-9878
- None

## Beschreibung

Die Erfindung betrifft ein Verfahren gemäß Patentanspruch 1.
Es sind Verfahren zur Erkennung von Lichtbögen, welche in einer Installationsanordnung auftreten, bekannt, bei welchen Verfahren versucht wird, einen Lichtbogen anhand bestimmter Muster in einem Frequenzspektrum zu erkennen. Bei diesen Verfahren wird ein Strom- und/oder Spannungssignal in der elektrischen Installationsanordnung aufgenommen und analysiert. Bekannt ist dabei etwa bestimmte spektrale Anteile, als Frequenzbereiche, zu bewerten, und das Strom- und/oder Spannungssignal hinsichtlich dem Auftreten bestimmter Muster in diesem Frequenzbereich zu untersuchen, um daraus auf das Auftreten eines Lichtbogens zu schließen. Derartige Verfahren haben sich in der Praxis als nachteilig bzw. als nicht sinnvoll umsetzbar erwiesen, da diese Verfahren tatsächlich auftretende gefährliche Lichtbögen oftmals nicht als solche erkennen können, und folglich im Fehlerfall keine Abschaltung des betreffenden Netzes veranlassen. Andererseits jedoch "erkennen" derartige Verfahren oftmals ungefährliche Ereignisse als "gefährlichen Lichtbogen" und verursachen eine sicherheitstechnisch unbegründete Netzabschaltung. Derartige bekannte Verfahren gewährleisten daher nur einen ungenügenden Schutz gegen die Wirkungen gefährlicher Lichtbögen, und stellen somit keinen wirksamen Schutz gegen lichtbogenverursachte Brände dar. Weiters verursachen derartige Verfahren aufgrund von Fehlabschaltungen eine geringe Netzverfügbarkeit. Aufgrund dieser erheblichen Nachteile wird daher oftmals auf den Einsatz derartiger Verfahren verzichtet, da viele Anwender eine mangelnde Netzverfügbarkeit aufgrund einer Fehlabschaltung als bewusst störendes Ereignis wahrnehmen, und die Gefahren durch Lichtbögen negieren.

Das Paper "Partial discharge source discrimination using a support vector machine" (Hao et al) beschreibt das Erkennen eines Lichtbogens mittels einer support vector machine SVM.

Die US 2008/084215 A1 zeigt eine Anordnung und ein Verfahren zur Isolationsüberwachung eines Inverters.

Die WO 01/18554 A1 offenbart eine Sensoranordnung zum Erkennen von Entladungen durch ein Dielektrikum eines Hochspannungstransformators, wobei ein Ultraschallsensor die Druckschwankungen innerhalb des Dielektrikums misst, und ein weitere Detektor elektromagnetische Wellen detektiert.

Aus der WO 98/35237 A2 geht ein System zur Lichtbogenerkennung hervor, wobei auch die Einspeisung eines simulierten Testsignals vorgesehen sein kann.

Die US 2010/241372 A1 beschreibt ein Überwachungssystem hinsichtlich Teilentladungen, wobei zwei an unterschiedlichen Positionen eines Leiters gemachte Messungen verglichen werden.

Die EP 1 439 396 A2 zeigt ein Verfahren zur Überwachung und Analyse des Teilentladungsverhaltens eines elektrischen Betriebsmittels, um den Zustand von dessen Isolation zu überwachen, wobei zu unterschiedlichen Zeitpunkten immer wieder entsprechende Messungen durchgeführt und verglichen werden

Die DE 197 58 085 A1 offenbart einen Impulsgenerator mit Stromeinprägung, welcher digital ausgebildet ist und auch gemessene Impulse nachformen kann.

Aufgabe der Erfindung ist es daher ein Verfahren der eingangs genannten Art anzugeben, mit welchem die genannten Nachteile vermieden werden können, und mit welchem sowohl eine hohe Netzverfügbarkeit als auch eine hohe Sicherheit gegen die Wirkungen auftretender Lichtbögen gegeben ist.

Erfindungsgemäß wird dies durch die Merkmale des Patentanspruches 1 erreicht.

Dadurch kann eine hohe Netzverfügbarkeit und eine hohe Sicherheit gegen die Wirkungen auftretender Lichtbögen erreicht werden. Dadurch können in der elektrischen Installationsanordnung auftretende Lichtbögen sicher erkannt werden, und von anderen elektrischen Ereignissen unterschieden werden. Dadurch wird ein Lichtbogensensor unmittelbar in der zu schützenden bzw. zu überwachenden elektrischen Umgebung an die Auswirkungen unterschiedlicher auftretender Lichtbögen trainiert. Dadurch können die tatsächlich und unter realen Bedingungen in der zu schützenden elektrischen Installationsanordnung auftretenden Auswirkungen eines Lichtbogens zur Bewertung elektrischer Ereignisse herangezogen werden, sowie zur Entscheidung, ob aufgrund eines elektrischen Ereignisses eine Abschaltung wenigstens eines Teils der elektrischen Installationsanordnung erfolgen soll, oder nicht. Dadurch können die messbaren Wirkungen auftretender elektrischer Ereignisse besonders gut hinsichtlich deren Ursache als Lichtbogenereignis bewertet bzw. erkannt werden.

Die Erfindung betrifft weiters ein Verfahren gemäß dem Oberbegriff des Patentanspruches 12.

Aufgabe der Erfindung ist es ein Verfahren der vorstehend genannten Art anzugeben, mit welchem die eingangs genannten Nachteile vermieden werden können, und mit welchem sowohl eine hohe Netzverfügbarkeit als auch eine hohe Sicherheit gegen die Wirkungen auftretender Lichtbögen gegeben ist.

Erfindungsgemäß wird dies durch die Merkmale des Patentanspruches 12 erreicht.

Dadurch können die vorstehend genannten Vorteile erzielt werden.

Die Erfindung betrifft weiters einen Lichtbogenschutzschalter gemäß dem Oberbegriff des Patentanspruches 17.

Aufgabe der Erfindung ist es einen Lichtbogenschutzschalter der vorstehend genannten Art anzugeben, mit welchem die eingangs genannten Nachteile vermieden werden können, und mit welchem sowohl eine hohe Netzverfügbarkeit als auch eine hohe Sicherheit gegen die Wirkungen auftretender Lichtbögen gegeben ist.

Erfindungsgemäß wird dies durch die Merkmale des Patentanspruches 17 erreicht.

Dadurch können die vorstehend genannten Vorteile erzielt werden.

Die Unteransprüche betreffen weitere vorteilhafte Ausgestaltungen der Erfindung. Ausdrücklich wird hiermit auf den Wortlaut der Ansprüche Bezug genommen, wodurch die Ansprüche an dieser Stelle durch Bezugnahme in die Beschreibung eingefügt sind und als wörtlich wiedergegeben gelten.

Die Erfindung wird unter Bezugnahme auf die beigeschlossenen Zeichnungen, in welchen lediglich bevorzugte Ausführungsformen beispielhaft dargestellt sind, näher beschrieben. Dabei zeigt:
Fig. 1 ein Blockschaltbild einer ersten Anordnung zur Durchführung eines gegenständlichen Verfahrens;
Fig. 2 ein Blockschaltbild einer zweiten Anordnung zur Durchführung eines gegenständlichen Verfahrens;
Fig. 3 ein Struktogramm eines ersten Verfahrens zur Auswahl eines Charakteristikums oder Algorithmus;
Fig. 4 ein Struktogramm eines zweiten Verfahrens zur Auswahl eines Charakteristikums oder Algorithmus; und
Fig. 5 ein Struktogramm eines dritten Verfahrens zur Auswahl eines Charakteristikums oder Algorithmus;

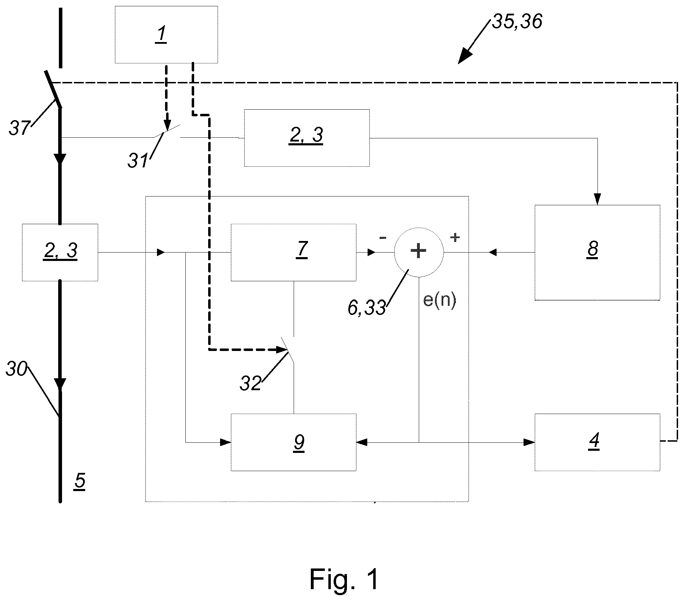

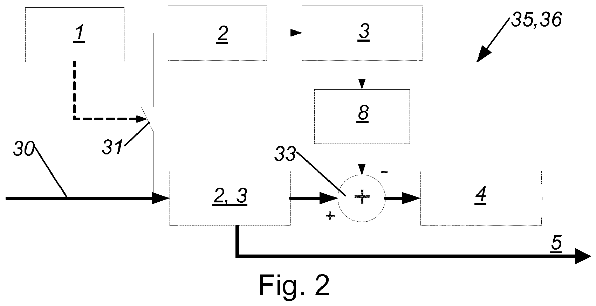

Die Fig. 1 und 2 zeigen jeweils eine Anordnung zur Umsetzung eines Verfahren zur Adaption eines Lichtbogensensors 35 an eine Position in einer elektrischen Installationsanlage, wobei wenigstens an einer ersten Position in der Installationsanlage eine vorgebbare Anzahl vorgebbarer Lichtbögen simuliert und/oder erzeugt werden, wobei jedem simulierten bzw. erzeugten Lichtbogen nachfolgend wenigstens ein Strom- und/oder Spannungsverlauf in einer Messwerterfassungseinheit aufgenommen wird, wobei wenigstens ein Charakteristikum der aufgenommenen Strom- und/oder Spannungsverläufe ermittelt und gespeichert wird, und dass der Lichtbogensensor 35 an die elektrischen Installationsanlage trainiert wird.

Dadurch kann eine hohe Netzverfügbarkeit und eine hohe Sicherheit gegen die Wirkungen auftretender Lichtbögen gegeben erreicht. Dadurch können in der elektrischen Installationsanordnung auftretende Lichtbögen sicher erkannt werden, und von anderen elektrischen Ereignissen unterschieden werden. Dadurch wird ein Lichtbogensensor 35 unmittelbar in der zu schützenden bzw. zu überwachenden elektrischen Umgebung an die Auswirkungen unterschiedlicher auftretender Lichtbögen trainiert werden. Dadurch können die tatsächlich und unter realen Bedingungen in der zu schützenden elektrischen Installationsanordnung auftretenden Auswirkungen eines Lichtbogens zur Bewertung elektrischer Ereignisse herangezogen werden, sowie zur Entscheidung, ob aufgrund eines elektrischen Ereignisses eine Abschaltung wenigstens eines teils der elektrischen Installationsanordnung erfolgen soll, oder nicht. Dadurch können die messbaren Wirkungen auftretender elektrischer Ereignisse besonders gut hinsichtlich deren Ursache als Lichtbogenereignis bewertet bzw. erkannt werden.

Die gegenständliche Erfindung ist auf ein Verfahren gerichtet, bei welchem ein Lichtbogensensor 35 "lernt" welche Wirkungen bzw. Spuren ein auftretender Lichtbogen in der tatsächlichen elektrischen Einsatzumgebung verursacht bzw. hinterlässt. Dabei ist der Lichtbogensensor 35 an einer Stelle bzw. Position innerhalb der elektrischen Installationsanordnung schaltungstechnisch angeordnet, und wird daran gewöhnt aus eben dieser Position aus den auftretenden elektrischen Wirkungen diejenigen zu erkennen, welche durch einen Lichtbogen verursacht wurden. Weiters umfasst die gegenständliche Erfindung ein Verfahren zum Schutz einer elektrischen Installationsanlage vor Lichtbögen bzw. deren Wirkungen, sowie einen Lichtbogenschutzschalter 36.

Einführend wird das Verfahren zur Adaption eines Lichtbogensensors 35 in einer elektrischen Installationsanlage, sowie bevorzugte Ausführungsformen desselben, beschrieben.

Bei einer elektrischen Installationsanlage handelt es sich bevorzugt um jede Art einer elektrischen Schaltungsanordnung, welche zur Bereitstellung und Versorgung mit elektrischer Energie vorgesehen und/oder geeignet ist. Insbesondere umfasst der Begriff Installationsanlagen im Bereich der Haustechnik.

Ein Lichtbogensensor 35 ist bevorzugt eine Vorrichtung, welche dazu vorgesehen und/oder ausgebildet ist, ein Ereignis bzw. die messbaren Wirkungen eines Ereignisses innerhalb einer elektrischen Schaltungsanordnung bzw. Installationsanlage ursächlich einem, insbesondere sog. gefährlichen, Lichtbogen zuzuordnen. Als "gefährlich" wird ein Lichtbogen insbesondere bezeichnet, wenn dessen Leistung ausreichend ist in der Umgebung des betreffenden Lichtbogens einen Brand zu verursachen. Die Einteilung in gefährliche und ungefährliche Lichtbögen ist daher möglicherweise neben der Leistung des Lichtbogens, auch von der jeweiligen Umgebung, und der Brennbarkeit bzw. Entzündbarkeit der Gegenstände in der jeweiligen Umgebung abhängig. Als brandverursachend wird in der Literatur etwa eine Verlustleistung von 60W an einer Fehlerstelle angegeben. Bevorzugt ist dabei vorgesehen, die jeweilige tatsächliche Umgebung der elektrischen Installationsanlage zu berücksichtigen, und etwa in feuerempfindlichen Umgebungen bereits Lichtbögen mit geringeren Leistungen als gefährliche Lichtbögen einzustufen.

Adaption bezeichnet die Anpassung der zur Erkennung von Lichtbögen verwendeten bzw. angewandten Methoden an die tatsächliche elektrische Umgebung des Lichtbogensensors 35. Der Lichtbogensensor 35 wird daher an die tatsächliche elektrische Umgebung gewöhnt bzw. trainiert. Auf bevorzugte Ausbildungen dieser Adaption wird im Weiteren eingegangen.

Es ist vorgesehen, dass der Lichtbogensensor 35 an einer Position innerhalb der elektrischen Installationsanordnung angeordnet ist bzw. wird.

Beim gegenständlichen Verfahren wird wenigstens an einer ersten Position in der Installationsanlage eine vorgebbare Anzahl vorgebbarer Lichtbögen simuliert und/oder erzeugt. Bevorzugt ist dabei vorgesehen an mehreren unterschiedlichen Positionen ebenfalls eine vorgebbare Anzahl vorgebbarer Lichtbögen zu simulieren und/oder zu erzeugen. Beim Erzeugen eines vorgebbaren Lichtbogens ist vorgesehen an der betreffenden ersten Position einen Lichtbogen tatsächlich zu verursachen. Hiefür sind bereits Testgeräte bekannt. Ein Simulieren eines Lichtbogens bezeichnet bevorzugt das Einspeisen eines breitbandigen elektrischen Signals, welches insbesondere die elektrischen Wirkungen eines Lichtbogens nahe an dessen Erscheinungsort wiedergibt.

Die Bezeichnung vorgebbarer Lichtbogen bezieht sich sowohl auf die Intensität bzw. Verlustleistung der simulierten bzw. erzeugten Lichtbögen, als auch auf die Art des Lichtbogens, im Sinne eines Lichtbogens an einer seriellen Leiterunterbrechung oder eines parallelen Lichtbogens. Es ist vorgesehen jeweils mehrere Lichtbogenereignisse an der wenigstens einen ersten Position zu erzeugen und/oder zu simulieren. Dadurch stehen für eine weitere Auswertung der nachfolgend aufgenommenen Messergebnisse statistisch aussagekräftige Daten zur Verfügung. Dadurch kann die Qualität der ermittelten Charakteristika gegenüber Einzelmessungen verbessert werden.

Es ist vorgesehen, dass jedem simulierten bzw. erzeugten Lichtbogen nachfolgend wenigstens ein Strom- und/oder Spannungsverlauf in bzw. von einer Messwerterfassungseinheit 2 aufgenommen wird. Dabei ist vorgesehen, den betreffenden Strom- und/oder Spannungsverlauf an dem Lichtbogensensor 35 bzw. durch den Lichtbogensensor 35 selbst aufzunehmen. Durch die Erzeugung bzw. Simulation der Lichtbögen an der ersten Position in der elektrischen Installationsanlage und der nachfolgenden Aufnahme der Strom- und/oder Spannungsverläufe an einer - von der ersten Position abweichenden - zweiten Position in der elektrischen Installationsanlage, an welcher der Lichtbogensensor 35 auch für die weitere Überwachung der elektrischen Installationsanlage angeordnet ist, sind die an der ersten Position erzeugten elektrischen Ströme und/oder Spannungen bis zu deren Aufnahme an der zweiten Position sämtlichen Einflüssen und Wirkungen der dazwischenliegenden Teile der elektrischen Installationsanlage ausgeliefert und werden durch diese verändert. Derartige Einflüsse sind etwa frequenzabhängige Transmission, Reflexion und/oder Dämpfung des breitbandigen Strom- und/oder Spannungsverlaufs, welcher als Folge eines Lichtbogens entsteht, an den elektrischen Leitern, an Abzweigungen, offenen Enden und/oder angeschlossenen Verbrauchern. Das als Folge eines Lichtbogens an der zweiten Position durch den Lichtbogensensor 35 feststellbare Strom- und/oder Spannungssignal kann daher deutliche Unterschiede zu dem entsprechenden Signal an der ersten Position aufweisen.

Es ist vorgesehen einen Strom- und/oder Spannungsverlauf aufzunehmen, welcher insbesondere breitbandig aufgenommen wird. Die obere Grenzfrequenz beträgt dabei bevorzugt etwa 20 MHz. Wobei auch größere Bandbreiten und höhere obere Grenzfrequenzen vorgesehen sein können. Bevorzugt ist vorgesehen, dass in einer Messwerterfassungseinheit 2 wenigstens ein Stromsensor und/oder ein Spannungssensor angeordnet sind, welche dazu ausgebildet sind, einen zeitlichen Verlauf des Stromes in den elektrischen Leitungen 30 und/oder die Spannung zwischen den Leitungen 30 als zeitabhängiges Signal aufzunehmen und auszugeben, wobei die Ausgabe sowohl analog, als auch in wert- und/oder zeitdiskreter, insbesondere digitaler, Form erfolgen kann.

Nachfolgend der Aufnahme der Strom- und/oder Spannungsverläufe ist vorgesehen, dass wenigstens ein Charakteristikum der aufgenommenen Strom- und/oder Spannungsverläufe ermittelt und/oder gespeichert wird. Jeweils wenn ind er gegenständlichen Ausführungen angeführt ist, dass etwas gespeichert wird, ist ein entsprechender Speicher bzw. ein Speichermedium vorgesehne, auch wenn dieses nicht explizit angeführt ist. Als Charakteristikum wird bevorzugt wenigstens eine gestalthafte bzw. typische Eigenart eines Strom- und/oder Spannungsverlaufs aufgefasst. Insbesondere werden als Charakteristikum Eigenarten der durch einen Lichtbogen verursachten Strom- und/oder Spannungsverläufe bevorzugt, welche eine deutliche Unterscheidung von anderen Strom- und/oder Spannungsverläufen innerhalb der elektrischen Installationsanlage ermöglichen. Hiefür kann vorgesehen sein, vor Durchführung des gegenständlichen Verfahrens sämtliche Verbraucher, insbesondere wenigstens kritische Verbraucher, welche etwa bei deren Betrieb ebenfalls Lichtbögen verursachen, wie beispielsweise Gleichstrommaschinen mit Bürsten, in Betrieb zu nehmen, und aus den dabei ermittelten Strom- und/oder Spannungsverläufen ebenfalls Charakteristika zu ermitteln. Diese Verbraucher-Charakteristika können gespeichert werden, um bei einer nachfolgenden Überwachung der elektrischen Installationsanlage auch unkritische Strom- und/oder Spannungsverläufe sicher als solche zu erkennen. Durch die Ermittlung und Speicherung wenigstens eines Charakteristikums kann daher eine sichere und an die jeweilige tatsächliche Installationsumgebung angepasste Zuordnung auftretender elektrischer Wirkungen zu gefährlichen oder sicheren Ursachen erfolgen.

Wie bereits dargelegt, kann als Charakteristikum jede Eigenart eines Strom- und/oder Spannungsverlaufs ermittelt und/oder gespeichert werden, welche eine hinreichende Unterscheidung dahingehend ermöglichen dürfte, ob es sich bei der Ursache um einen gefährlichen Lichtbogen oder ein anderes, insbesondere ungefährliches, elektrisches Ereignis handelt.

Nachfolgen werden besonders als Charakteristikum im gegenständlichen Sinn bevorzugte Eigenschaften angeführt, wobei eine Kombination mehrerer der angeführten bevorzugten Charakteristika vorgesehen sein kann.

Gemäß einer bevorzugten Ausbildung des gegenständlichen Verfahrens ist vorgesehen, dass als wenigstens eines Charakteristikum wenigstens ein vorgebbarer Teil eines Zeitverlaufes und/oder einer Hüllkurve des Zeitverlaufes des Strom- und/oder Spannungsverlaufs ermittelt und/oder gespeichert wird. Dadurch kann die Zeitdauer des Ereignisses und eine allfällige Periodizität, sowie gegebenenfalls deren Frequenz, zur Beurteilung eines zu einem späteren Zeitpunkt gemessenen Strom- und/oder Spannungsverlaufs herangezogen werden, wodurch eine gute Unterscheidung zwischen fehlerhaft auftretenden Lichtbögen, welche aperiodisch und unvorhersagbar auftreten, und anderen, insbesondere regelmäßig auftretenden, Ereignissen getätigt werden. Dadurch kann weiters die Leistung an der Fehlerstelle ermittelt bzw. auf diese rückgeschlossen werden, und berücksichtigt werden. Dadurch können auch wiederholt auftretende Fehler erkannt werden, sowie ein Abklingen oder Verlöschen eines Lichtbogens.

In diesem Zusammenhang kann vorgesehen sein, dass als wenigstens eines Charakteristikum eine Anzahl ausgefallener Halbwellen des Strom- und/oder Spannungsverlaufs ermittelt und/oder gespeichert wird. Dadurch kann ebenfalls wirksam ein elektrisches Ereignis als Fehler erkennt werden, da solche zufällig auftreten.

Weiters kann vorgesehen sein, dass als wenigstens eines Charakteristikum wenigstens ein vorgebbarer Teil eines Frequenzspektrums und/oder eine Hüllkurve des Frequenzspektrums des Strom- und/oder Spannungsverlaufs ermittelt und/oder gespeichert wird. Durch die Analyse in Frequenzbereich können gefährliche Lichtbögen gut erkannt werden, da diese in bestimmten Frequenzbereichen typische Wirkungen in Strom- und/oder Spannungsverläufen zeigen. Aufgrund der Einbindung der Übertragungseigenschaften der realen elektrischen Installationsanlage kann aus den aufgenommenen Strom- und/oder Spannungsverläufen nunmehr tatsächlich auf das Auftreten eines gefährlichen Lichtbogens geschlossen werden.

Dabei kann etwa vorgesehen sein, dass als wenigstens eines Charakteristikum ein Amplitudenwert in einem vorgebbaren Frequenzband ermittelt und/oder gespeichert wird. Dies weist den Vorteil einer hohen Unterscheidungskraft zwischen gefährlichen Lichtbogenereignissen und ungefährlichen anderen Ereignissen auf. Weiters führt dies zu einer technisch einfachen Implementierung bzw. Umsetzung.

Zusätzlich bzw. alternativ kann vorgesehen sein, dass als wenigstens eines Charakteristikum eine Phasenverschiebung des Strom- und/oder Spannungsverlaufs ermittelt und/oder gespeichert wird. Die Detektion einer Phasenverschiebung zwischen dem Strom- und dem Spannungsverlauf ist technisch einfach umsetzbar, und ermöglicht einen Rückschluss auf einen beteiligten Verbraucher bzw. die Art der Fehlerstelle.

Es ist vorgesehen die aufgenommenen Strom- und/oder Spannungsverläufe hinsichtlich wenigstens einem Charakteristikum, insbesondere wenigstens einem der vorstehend als bevorzugt beschriebenen Charakteristika, zu untersuchen bzw. zu analysieren. Dabei kann jedes technische Verfahren vorgesehen sein, um die angeführte wenigstens eine Eigenschaft bzw. das Charakteristikum aus den aufgenommenen Strom- und/oder Spannungsverläufen zu ermitteln.

Insbesondere ist vorgesehen, dass die aufgenommenen Strom- und/oder Spannungsverläufe vorgebbar in einem Zeit- und/oder einem Bildbereich, insbesondere einem Frequenzbereich, analysiert werden, zur Ermittlung des wenigstens einen Charakteristikums. Hiezu ist bevorzugt vorgesehen, dass ein Lichtbogendetektor eine Transformationseinheit, insbesondere zur Durchführung einer FFT, einer Gabor-Transformation und/oder einer Wavelet-Transformation, umfasst.

Wie bereits angedacht, ist bevorzugt vorgesehen, zu jeder Art eines erzeugten und/oder simulierten Lichtbogens, jeweils mehrere derartige Lichtbögen zu erzeugen und/oder zu simulieren. Dadurch können besser die tatsächlichen Charakteristika erkannt und ermittelt werden, da Einzelereignissen in der Regel eine geringe Aussagekraft zukommt.

Bevorzugt ist daher in diesem Zusammenhang vorgesehen, dass aus einer vorgebbaren Anzahl ermittelter Charakteristika ein Mittelwert und/oder eine Standardabweichung ermittelt wird. Dadurch kann ein deutlich aussagekräftigerer Wert in Form eines Charakteristika-Mittelwerts ermittelt werden, wobei durch Ermittlung der Varianz bzw. Standardabweichung weiters ein Gütewert für diesen Charakteristika-Mittelwert zur Verfügung steht. Bei einer nachfolgenden Überprüfung eines aufgenommenen Strom- und/oder Spannungsverlaufs hinsichtlich dessen Ursache in einem gefährlichen Lichtbogenereignis, ist bevorzugt vorgesehen, den nunmehr aufgenommenen Strom- und/oder Spannungsverlauf den gleichen mathematischen Verfahren zu unterwerfen, welche angewandt wurden, um des gespeicherte Charakteristikum zu ermitteln, und den derart bearbeiteten Strom- und/oder Spannungsverlauf mit dem gespeicherten Charakteristika-Mittelwert zu vergleichen, wobei bereits eine Annäherung des eben neu bearbeiteten Strom- und/oder Spannungsverlaufs innerhalb eines vorgebbaren Intervalls um den Charakteristika-Mittelwert, als Erfüllung des Charakteristika-Mittelwerts angesehen werden kann. Dabei kann die "Breite" des betreffenden Intervalls eine Funktion der Standardabweichung sein. Daher, dass bei einer geringen Standardabweichung des gespeicherten Charakteristika-Mittelwerts ein kleines Intervall vorgegeben wird, und dass bei einer großen Standardabweichung ein großes Intervall vorgegeben wird.

Die Art und Weise wie der Lichtbogensensor 35 mittels der ermittelten Charakteristika adaptiert wird, kann unterschiedlich ausgebildet sein. Nachfolgend werden zwei bevorzugte Ausführungsformen eines entsprechende ausgebildeten Lichtbogensensors 35 anhand der Fig. 1 bis 2 näher beschrieben.

Die jeweils beschriebenen Anordnungen sind als Lichtbogenschutzschalter 36 umfassend einen Lichtbogensensor 35 ausgebildet, mit wenigstens einer, als Stromsensor und/oder Spannungssensor ausgebildeter Messwerterfassungseinheit 2 zur Aufnahme eines Strom- bzw. Spannungsverlaufes, sowie mit Schaltkontakten 37 zur vorgebbaren Unterbrechung einer elektrischen Verbindung innerhalb einer elektrischen Installationsanlage, wobei der Lichtbogenschutzschalter 36 eine elektrische Schaltungsanordnung aufweist, zur Durchführung eines Verfahrens zur Adaption eines Lichtbogensensors 35 in einer elektrischen Installationsanlage und/oder eines - nachstehend beschriebenen - Verfahrens zum Schutz einer elektrischen Installationsanlage vor Lichtbögen, und die Schaltungsanordnung wenigstens mittelbar mit den Schaltkontakten 37 wirkverbunden ist. Die angeführten Schaltkontakte 37 sind in den Figuren lediglich symbolisch dargestellt. Weitere in der Regel bei derartigen Schalters vorgesehene Baugruppen, wie ein Schaltwerk bzw. Schaltschloss sind nicht dargestellt. Diese Baugruppen sind bevorzugt hinsichtlich deren Auslegung und Ausgestaltung an die entsprechenden Baugruppen in Leistungsschutzschaltern und/oder Fehlerstromschutzschaltern angelehnt. Bevorzugt ist vorgesehen, dass die elektrische Schaltungsanordnung einen Mikrokontroller umfasst.

Wie vorstehend bereits angedacht, umfasst die gegenständliche Erfindung weiters ein Verfahren zum Schutz einer elektrischen Installationsanlage vor Lichtbögen, wobei wenigstens ein elektrischer Strom- und/oder Spannungsverlauf aufgenommen wird, welcher nachfolgend mit wenigstens einem, nach einem vorstehenden Verfahren ermittelten Charakteristikum verglichen oder einem - nachfolgend noch erläuterten - Algorithmus bewertet wird, wobei bei einer vorgebbaren Annäherung wenigstens einer Eigenschaft des ermittelten Strom- und/oder Spannungsverlaufs mit dem wenigstens einen ermittelten Charakteristikum oder einem vorgebbaren Grenzwert wenigstens ein Teil der elektrischen Installationsanlage abgeschaltet wird. Dadurch können zum Schutz der elektrischen Installationsanlage aufgenommene Strom- und/oder Spannungsverläufe mit tatsächlich am Ort der Aufnahme der Strom- und/oder Spannungsverläufe ermittelten Charakteristika verglichen werden. Dadurch kann der Schutz elektrischer Anlagen, sowie deren Umgebung vor den schädlichen und gefährlichen Auswirkungen von Lichtbögen besonders gut erfolgen, und gleichzeitig eine hohe Netzverfügbarkeit durch weitestgehende Vermeidung von Fehlauslösungen erzielt werden.

Weitere bevorzugte Verfahrensschritte werden an gegebener Stelle bei der Beschreibung besonders bevorzugter Lichtbogenschutzschalter 36 angeführt.

Fig. 1 zeigt ein Blockschaltbild einer ersten Anordnung zur Durchführung eines gegenständlichen Verfahrens bzw. einer ersten bevorzugten Ausführung eines Lichtbogenschutzschalters 36 mit einem Lichtbogensensor 35.

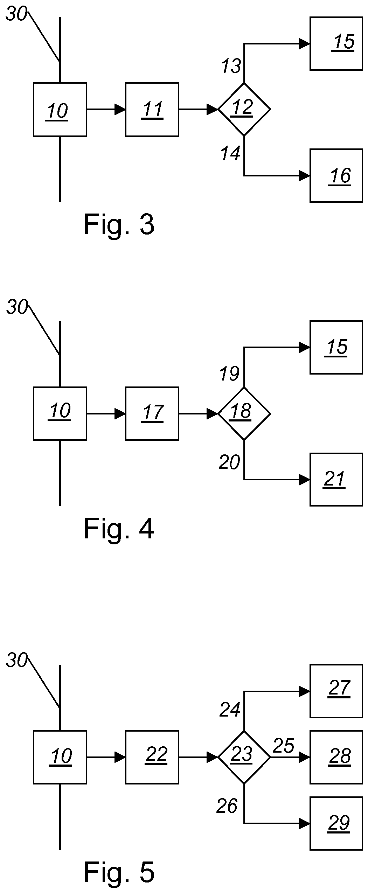

Der Lichtbogenschutzschalter 36 weist dabei ein adaptives Filter 6 auf. Zum Adaptieren schließt die Steuereinheit 1, welche etwa einen Mikrocontroller aufweist, den ersten Schalter 31, wodurch wenigstens eine Leitung 30 bzw. ein Leitungspaar der elektrischen Installationsanlage schaltungstechnisch mit der Messwerterfassungseinheit 2 verbunden wird. Es ist vorgesehen, dass die Steuereinheit 1 Eingabemittel aufweist, bzw. mit solchen wenigstens temporär verbindbar ist, etwa über eine Schnittstelle, wie etwa RS-232 und/oder USB. Dadurch können der Steuereinheit Befehle übermittelt werden, und der Übergang zwischen verschiedenen Betriebsmodi kann veranlasst werden. Weiters ist die Steuereinheit 1 bevorzugt wenigstens temporär mit wenigstens einem Anzeigemittel verbunden, wodurch eine Überwachung eines Zustandes erfolgen kann. Dadurch kann die erforderliche Interaktion bei der Adaption des Lichtbogensensors 35 erfolgen. Etwa hinsichtlich der Art des Lichtbogens, ob dieser simuliert oder tatsächlich erzeugt wird, ob es sich um einen parallelen oder seriellen Lichtbogen handelt, usw., sowie hinsichtlich der Anzahl der Lichtbögen. Die gegenständlichen Ausführungen zur Steuereinheit 1 sind auch auf die weiters beschriebenen Ausführungsformen gemäß den Fig. 2 und 3 anwendbar.

Die Messwerterfassungseinheit 2 ermittelt den Strom- und/oder Spannungsverlauf als Funktion der Zeit. Die Messwerterfassungseinheit 2 weist hiezu geeignete Messgeräte auf, wobei insbesondere die Ermittlung eines digitalen Strom- und/oder Spannungsverlaufs vorgesehen ist. Gemäß der dargestellten bevorzugten Ausführungsform umfasst die Messwerterfassungseinheit 2 weiters eine Transformationseinheit 3, in welcher der Strom- und/oder Spannungsverlauf vom Zeitbereich in einen Bildbereich, insbesondere den Frequenzbereich, transformiert wird. Das transformierte Signal liegt nachfolgend an einer Rechen- und/oder Speichereinheit 8 an. Dabei ist vorgesehen, dass im Bereich der Rechen- und/oder Speichereinheit 8 wenigstens ein hinsichtlich dessen Typ vorgegebenes Charakteristikum aus dem ermittelten Strom- und/oder Spannungsverlauf bzw. dem transformierten Signal, welches etwa als Spektrum vorliegt, ermittelt wird. Dabei kann auch die Ermittlung mehrerer Charakteristika vorgesehen sein. Besonders bevorzugt ist vorgesehen aus mehreren ermittelten Charakteristika auf Basis ein und desselben simulierten bzw. erzeugten Lichtbogentyps einen Mittelwert zu bilden.

Bevorzugt ist nunmehr vorgesehen, dass in einer Adaptionsphase das adaptive Filter 6 eines Lichtbogenschutzschalters 36, insbesondere gemäß Fig. 1, mit den Charakteristika, insbesondere mit einem entsprechenden Mittelwert, eingestellt wird. Dabei wird dem adaptiven Filter 6 an beiden Seiten dasselbe elektrische Signal angelegt. Hiefür kann eine weitere Verbindung von der Messwerterfassungseinheit 2 zu einer variablen Filterbaugruppe 7 vorgesehen sein, oder - wie in Fig. 1 - eine zweite Messwerterfassungseinheit 2, welche schaltungstechnisch mit der variablen Filterbaugruppe 7 verbunden ist. Der Ausgang der variablen Filterbaugruppe 7 ist mit einem invertierenden Eingang des adaptiven Filters 6 verbunden, dessen nicht-invertierender Eingang mit der Rechen- und/oder Speichereinheit 8 verbunden ist. Bevorzugt ist die Verwendung lediglich einer einzigen Messwerterfassungseinheit 2 vorgesehen, da dadurch die Genauigkeit der Anpassung bzw. Adaptierung des Lichtbogensensors nicht durch geringfügige Unterschiede, wie etwa unterschiedliches Rauschverhalten, zweier Messwerterfassungseinheiten 2 beeinträchtigt wird. Selbiges gilt auch für die bevorzugte Implementierung der Transformationseinheit 3.

Der Ausgang der zweiten Messwerterfassungseinheit 2 ist weiters mit einer sog. Vergleichs- und/oder Regeleinheit 9 verbunden. Diese ist weiters mit dem Ausgang des adaptiven Filters 6 selbst verbunden. Bei erfolgreicher Adaption des adaptiven Filters 6 wird das Signal am Ausgang des adaptiven Filters 6 sehr klein, insbesondere bei perfekter - und in der Realität kaum zu erwartender - Anpassung null. Durch Vergleich des Ausgangssignals der zweiten Messwerterfassungseinheit 2 mit dem Ausgang des adaptiven Filters 6 wird wenigstens ein Korrekturwert ermittelt, mit welchem die variable Filterbaugruppe 7 derart justiert wird, dass das Signal am Ausgang des adaptiven Filters 6 sehr klein, insbesondere null, wird. Dabei ist bevorzugt vorgesehen, dass die Anpassung der variablen Filterbaugruppe 7 mithilfe rekursiver mathematischer Verfahren bzw. Algorithmen erfolgt, welche in der Vergleichs- und/oder Regeleinheit 9 durchgeführt werden.

Bei der Ausführungsform gemäß Fig. 1 kann der gesamte Zeitverlauf und/oder das gesamte Spektrum des Strom- und/oder Spannungsverlaufs das wenigstens eine Charakteristikum darstellen. Es kann aber auch vorgesehen sein, dass in der Messwerterfassungseinheit 2 bzw. der Transformationseinheit 3 wenigstens eines der vorstehend erläuterten Charakteristika ermittelt wird, wobei in diesem Fall das variable Filter auch nur auf dieses wenigstens eine Charakteristikum angewandt wird.

Nach der entsprechend beschriebener Adaption der Vorrichtung gemäß Fig. 1 wird in dem nachfolgenden Betrieb zur Überwachung einer elektrischen Installationsanordnung hinsichtlich auftretender gefährlicher Lichtbögen der Strom- und/oder Spannungsverlauf in dem wenigstens einen Leiter überwacht, und durch die Messwerterfassungseinheit 2 bzw. die Transformationseinheit 3 entsprechend der Ermittlung des wenigstens einen Charakteristikums behandelt. Nachfolgend wird das derart gebildete Signal mit der variablen Filterbaugruppe 7 gefiltert und dem invertierenden Eingang des adaptiven Filters 6, welcher adaptiver Filter 6 durch eine diskrete Additionseinheit 33 in Fig. 1 - als besonders bevorzugte Ausführungsform - veranschaulicht ist, zugeführt. Dem nicht-invertierendem Eingang des adaptiven Filters 6 wird das in der Rechen- und/oder Speichereinheit 8 gespeicherte vorermittelte wenigstens eine Charakteristikum zugeführt. Desto größer die Übereinstimmung zwischen den gespeicherten Charakteristika und dem neu ermittelten "Eigenschaften" des Strom- und/oder Spannungsverlaufs ist, desto kleiner wird der Wert am Ausgang des adaptiven Filters 6. In der Auslöseeinheit 4 wird das Ausgangsignal des adaptiven Filters 6 hinsichtlich dem Unterschreiten eines vorgebbaren und gespeicherten Vergleichswertes überprüft. Bei Unterschreiten des Vergleichswerts durch den Wert des Signals am Ausgang des adaptiven Filters 6 wird von einem Auftreten eines gefährlichen Lichtbogens ausgegangen, woraufhin die Auslöseeinheit 4 das Öffnen der Trenn- bzw. Schaltkontakte 37 veranlasst.

FIG.2 zeigt ein Blockschaltbild einer zweiten Anordnung zur Durchführung eines gegenständlichen Verfahrens bzw. einer zweiten bevorzugten Ausführung eines Lichtbogenschutzschalters 36 mit einem Lichtbogensensor 35. Dabei wurde auf eine Darstellung der Trennkontakte verzichtet.

Hinsichtlich der bevorzugten Ausführungen der einzelnen Baugruppen wird auf die vorstehenden Erläuterungen zu Fig. 1 verwiesen. Nachfolgend werden lediglich die funktionalen Zusammenwirkungen bzw. schaltungstechnischen Verbindungen erläutert.

Ein Lichtbogensensor 35 gemäß der zweiten bevorzugten Ausführungsform weist eine Steuereinheit 1, zwei Messwerterfassungseinheiten 2 sowie bevorzugt auch zwei Transformationseinheit 3, eine Rechen- und/oder Speichereinheit 8, eine Auslöseeinheit 4, einen ersten Schalter 31, sowie eine Additionseinheit 33 auf, welche gemäß der bevorzugten digitalen Umsetzung des Lichtbogensensors 35 nach Fig. 2 als diskrete Additionseinheit 33 ausgebildet ist.

Über den ersten Schalter 31, welcher von der Steuereinheit gesteuert wird, ist der wenigstens eine Leiter 30 schaltungstechnisch mit der Messwerterfassungseinheit 2 verbunden. Die Messwerterfassungseinheit 2 ist schaltungstechnisch mit der Transformationseinheit 3 verbunden, welche selbst wiederum mit der Rechen- und/oder Speichereinheit 8 verbunden ist, deren Ausgang an einem invertierenden Eingang der Additionseinheit 33 anliegt. In dem Leiter 30 ist weiters eine Messwerterfassungseinheiten 2, welche weiters eine Transformationseinheit 3 umfasst, angeordnet, deren Ausgang an einem nicht-invertierenden Eingang der Additionseinheit 33 anliegt. Der Ausgang der Additionseinheit 33 liegt an der Auslöseeinheit 4.

Bei der Adaption des Lichtbogensensors 35 wird der erste Schalter 31 durch die Steuereinheit 1 geschlossen, und die Erzeugung bzw. Simulation der vorgebbaren Lichtbögen durchgeführt. Dabei werden Strom- und/oder Spannungsverläufe durch die Messwerterfassungseinheit 2 aufgenommen und in der Transformationseinheit 3 in den Bildbereich transformiert. Aus dem dabei ermittelten Spektrum wird wenigstens ein Charakteristikum ermittelt, welches in der Rechen- und/oder Speichereinheit 8 gespeichert wird.

Bei der nachfolgenden Überwachung der elektrischen Installationsanlage werden die jeweils durch die weitere Messwerterfassungseinheit 2 aufgenommenen und die Transformationseinheit 3 bearbeiteten Strom- und/oder Spannungsverläufe an den nicht-invertierenden Eingang der Additionseinheit 33 angelegt. Desto größer die Übereinstimmung zwischen den gespeicherten Charakteristika und den neu ermittelten Eigenschaften des Strom- und/oder Spannungsverlaufs ist, desto kleiner wird der Wert am Ausgang der Additionseinheit 33. In der Auslöseeinheit 4 wird das Ausgangsignal der Additionseinheit 33 hinsichtlich dem Unterschreiten eines vorgebbaren und abgelegten Vergleichswertes überprüft. Bei Unterschreiten des Vergleichswerts durch das Ausgangssignal der Additionseinheit 33 wird von einem Auftreten eines gefährlichen Lichtbogens ausgegangen, woraufhin die Auslöseeinheit 4 das Öffnen der - nicht dargestellten - Trennkontakte veranlasst.

Es kann vorgesehen sein, dass in einem Lichtbogendetektor 35 bzw. einem Lichtbogenschutzschalter 36 lediglich eine einzige Vorrichtung, entsprechend einer der vorstehenden bevorzugten Ausführungsformen implementiert ist. Es kann aber auch eine vorgebbare Mehrzahl derartiger Vorrichtungen je Lichtbogendetektor 35 bzw. Lichtbogenschutzschalter 36 vorgesehen sein. Dabei kann etwa jeweils ein unterschiedliches Charakteristikum vorgesehen sein, oder etwa ein bestimmtes Frequenzband.

Weiters kann vorgesehen sein, den Lichtbogensensor 35 nicht nur hinsichtlich dem Erkennen gefährlicher Lichtbögen zu adaptieren, sondern weiters - entsprechend der vorbeschriebenen Verfahren - auch dahin gehend zu adaptieren, dass der Lichtbogensensor 35 auch Verbraucher innerhalb der elektrischen Installationsanlage erkennt, welche aufgrund von Erfahrungen zu Fehlauslösungen führen können, etwa Schweißgeräte, oder große Elektromotoren mit Bürsten. Dabei kann vorgesehen sein, den Lichtbogensensor 35 in wenigstens einer der vorbeschriebenen Weisen an den Verbraucher zu adaptieren, wobei die dabei ermittelten Charakteristika in einem separaten Speicher abgelegt werden oder entsprechend gekennzeichnet werden, sodass bei deren Erfüllen durch die Eigenschaften eines später aufgenommenen Strom- und/oder Spannungsverlaufs keine Auslösung der Trenn- bzw. Schaltkontakte 37 veranlasst wird.

Neben der bislang alleinigen Beschreibung der Ermittlung wenigstens eines Charakteristikums, sowie der weiteren Überprüfung nachfolgend ermittelter Strom- und/oder Spannungsverläufe auf das Erfüllen des wenigstens einen Charakteristikums, ist weiters bevorzugt vorgesehen, dass wenigstens ein Charakteristikum in wenigstens einen ersten mathematischen Algorithmus aufgenommen wird. Dabei ist insbesondere vorgesehen, dass das wenigstens eine Charakteristikum die Form einer, insbesondere komplexen, Zahl aufweist, und dass wenigstens einer mathematischen Größe in dem ersten mathematischen Algorithmus das betreffende Charakteristikum zugewiesen wird. Dabei ist vorgesehen, dass bei der Überwachung der elektrischen Installationsanlage die ermittelten Strom- und/oder Spannungsverläufe mittels des ersten Algorithmus bewertet werden, und das dabei ermittelte Ergebnis bzw. die Eigenschaft durch die Auslöseeinheit 4 überwacht wird.

Bei den bislang beschrieben Verfahren und deren Umsetzung wird, bei der Überwachung der elektrischen Installationsanlage ein Strom- und/oder Spannungsverlauf auf das Erfüllen wenigstens eines Charakteristikums überprüft. Dabei kann wie beschrieben eine mehrfache, insbesondere parallele, Ausführung der jeweiligen Anordnung vorgesehen sein. Es kann jedoch auch vorgesehen sein, dass Gruppen unterschiedlicher Charakteristika, insbesondere Gruppen von Mittelwerten von Charakteristika, in einer Bibliothek gespeichert werden. Ebenso könne unterschiedliche Algorithmen in einer derartigen Bibliothek abgelegt sein bzw. werden. Eine solche Bibliothek ist bevorzugt im Bereich der Rechen- und/oder Speichereinheit 8 angeordnet.

Dabei ist bevorzugt vorgesehen, dass bei der Überwachung der elektrischen Installationsanlage, das Charakteristikum oder der Algorithmus aus einer vorgebbaren Anzahl gespeicherter Charakteristika bzw. Algorithmen vorgebbar ausgewählt wird.

Die beschriebene Auswahl eines Charakteristikums oder Algorithmus kann dabei bei jeder der beschriebenen Ausbildungen eines Lichtbogensensors 35, Lichtbogenschutzschalters 36 bzw. einem entsprechenden Verfahren zum Betrieb derartiger Vorrichtungen vorgesehen sein.

Hinsichtlich der Auswahl eines konkreten Charakteristikums oder Algorithmus aus der vorgebbaren Anzahl gespeicherter Charakteristika bzw. Algorithmen kann jede Art eines derartigen Auswahlverfahrens vorgesehen sein. Nachstehend werden anhand der in den Fig. 3 bis 5 drei bevorzugte Auswahlverfahren beschrieben.

Gemäß einem ersten bevorzugten Verfahren zur Auswahl eines Charakteristikums oder Algorithmus ist vorgesehen, dass zur Auswahl des Charakteristikums oder des Algorithmus die Anzahl der auftretenden bzw. ausgefallenen Halbwellen festgestellt wird. Fig. 3 zeigt ein Struktogramm eines derartigen ersten Verfahrens.

Dabei wird in einem ersten Schritt 10 eine Messung des Strom- und/oder Spannungsverlaufes in der Leitung 30 durchgeführt. In einem weiteren Schritt 11 wird die Anzahl der vorhandenen Halbwellen bzw. der ausgefallenen Halbwellen des gemessenen Strom- und/oder Spannungsverlaufes ermittelt. Nachfolgend wird in Schritt 12 ein Verhältnis zwischen Soll- und Ist-Anzahl der Halbwellen des gemessenen Strom- und/oder Spannungsverlaufes ermittelt. Sofern festgestellt wird, dass das Verhältnis der Halbwellen des gemessenen Strom- und/oder Spannungsverlaufes 2:2 beträgt, wird in Pfad 13 ein erster Algorithmus 15 ausgewählt, bei welchem die Anzahl der Nullstellen und die Amplitude in einem Frequenzband um 1 MHz untersucht und bewertet wird. Sofern festgestellt wird, dass das Verhältnis der Halbwellen des gemessenen Strom- und/oder Spannungsverlaufes von 2:2 abweichend ist, und etwa 2:1 oder 2:0 beträgt, wird in Pfad 14 ein zweiter Algorithmus 16 ausgewählt, welcher zweite Algorithmus auf das Erkennen und Bewerten aperiodischer Stromunterbrechungen abgestellt ist.

Gemäß einem zweiten bevorzugten Verfahren zur Auswahl eines Charakteristikums oder Algorithmus ist vorgesehen, dass zur Auswahl des Charakteristikums oder des Algorithmus eine erste Amplitude in einem ersten Frequenzband, und eine zweite Amplitude in einem zweiten Frequenzband festgestellt wird, dass die erste Amplitude mit der zweiten Amplitude verglichen wird. Fig. 4 zeigt ein Struktogramm eines derartigen zweiten Verfahrens.

Dabei wird in einem ersten Schritt 10 eine Messung des Strom- und/oder Spannungsverlaufes in der Leitung 30 durchgeführt. In einem weiteren Schritt 17 werden die maximalen Amplituden in einer vorgegebenen Auswahl an Frequenzbereichen, etwa einem Bereich um 1 MHz und einem Bereich um 15 MHz, des gemessenen Strom- und/oder Spannungsverlaufes ermittelt. Nachfolgend wird in Schritt 18 ermittelt, in welchem der vorgegebenen Frequenzbereiche sich das Amplitudenmaximum befindet. Sofern festgestellt wird, dass sich das Amplitudenmaximum im Frequenzbereich um 1 MHz befindet, wird in Pfad 19 der erste Algorithmus 15 ausgewählt, bei welchem die Anzahl der Nullstellen und die Amplitude in einem Frequenzband um 1 MHz untersucht und bewertet wird. Sofern festgestellt wird, dass sich das Amplitudenmaximum im Frequenzbereich um 15 MHz befindet, wird in Pfad 20 ein dritter Algorithmus 21 ausgewählt, welcher dritte Algorithmus auf diesen Frequenzbereich abgestellt ist, und etwa eine logarithmische Signalverstärkung umfasst.

Gemäß einem dritten bevorzugten Verfahren zur Auswahl eines Charakteristikums oder Algorithmus ist vorgesehen, dass zur Auswahl des Charakteristikums oder des Algorithmus eine Phasenverschiebung zwischen einem Stromverlauf und einem Spannungsverlauf festgestellt wird. Fig. 5 zeigt ein Struktogramm eines derartigen dritten Verfahrens.

Dabei wird in einem ersten Schritt 10 eine Messung des Strom- und/oder Spannungsverlaufes in der Leitung 30 durchgeführt. In einem weiteren Schritt 22 wird eine Phasenverschiebung zwischen den jeweiligen Spannungen u und Strömen i innerhalb des Strom- und/oder Spannungsverlaufes gemessen. Nachfolgend wird in Schritt 23 die Art des Verbrauchers ermittelt, daher ob es sich um einen vornehmlich induktiven, ohmschen oder kapazitiven Verbraucher handelt. Hiezu wird festgestellt, ob die jeweilige Spannung dem jeweiligen Strom voreilt, nacheilt oder gleichphasig zu diesem ist.

Sofern festgestellt wird, dass die Spannung dem Strom voreilt, handelt es sich um einen induktiven Verbraucher, und in Pfad 24 wird der vierte Algorithmus 27 ausgewählt, welcher auf die Bewertung induktiver Verbraucher bzw. Fehler abgestellt ist.

Sofern festgestellt wird, dass die Spannung gleichphasig zum Strom ist, handelt es sich um einen ohmschen Verbraucher, und in Pfad 25 wird der fünfte Algorithmus 28 ausgewählt, welcher auf die Bewertung ohmschcr Verbraucher bzw. Fehler abgestellt ist.

Sofern festgestellt wird, dass die Spannung dem Strom nacheilt, handelt es sich um einen kapazitiven Verbraucher, und in Pfad 26 wird der sechste Algorithmus 29 ausgewählt, welcher auf die Bewertung kapazitiver Verbraucher bzw. Fehler abgestellt ist.

## Patentansprüche

1. Verfahren zur Adaption und/oder zum Training eines Lichtbogensensors (35) unmittelbar in einer zu schützenden und/oder zu überwachenden elektrischen Installationsanlage an die Auswirkungen unterschiedlicher auftretender Lichtbögen, wobei wenigstens an einer ersten Position in der Installationsanlage eine vorgebbare Anzahl vorgebbarer Lichtbögen simuliert und/oder erzeugt werden, wobei jedem simulierten bzw. erzeugten Lichtbogen nachfolgend wenigstens ein Strom- und/oder Spannungsverlauf aufgenommen wird, wobei wenigstens ein Charakteristikum der aufgenommenen Strom- und/oder Spannungsverläufe ermittelt und/oder gespeichert wird, **dadurch gekennzeichnet, dass** als wenigstens ein Charakteristikum eine Anzahl ausgefallener Halbwellen des Strom- und/oder Spannungsverlaufs ermittelt und/oder gespeichert wird.

2. Verfahren nach Anspruch 1, **dadurch gekennzeichnet, dass** die aufgenommenen Strom- und/oder Spannungsverläufe vorgebbar in einem Zeit- und/oder einem Bildbereich, insbesondere einem Frequenzbereich, analysiert werden, zur Ermittlung des wenigstens einen Charakteristikums.

3. Verfahren nach Anspruch 1 oder 2, **dadurch gekennzeichnet, dass** als wenigstens ein Charakteristikum wenigstens ein vorgebbarer Teil eines Zeitverlaufes und/oder einer Hüllkurve des Zeitverlaufes des Strom- und/oder Spannungsverlaufs ermittelt und/oder gespeichert wird.

4. Verfahren nach einem der Ansprüche 1 bis 3, **dadurch gekennzeichnet, dass** als wenigstens ein Charakteristikum wenigstens ein vorgebbarer Teil eines Frequenzspektrums und/oder eine Hüllkurve des Frequenzspektrums des Strom- und/oder Spannungsverlaufs ermittelt und/oder gespeichert wird.

5. Verfahren nach einem der Ansprüche 1 bis 4, **dadurch gekennzeichnet, dass** als wenigstens ein Charakteristikum ein Amplitudenwert in einem vorgebbaren Frequenzband ermittelt und/oder gespeichert wird.

6. Verfahren nach einem der Ansprüche 1 bis 5, **dadurch gekennzeichnet, dass** als wenigstens ein Charakteristikum eine Phasenverschiebung des Strom- und/oder Spannungsverlaufs ermittelt und/oder gespeichert wird

7. Verfahren nach einem der Ansprüche 1 bis 6, **dadurch gekennzeichnet, dass** aus einer vorgebbaren Anzahl ermittelter Charakteristika ein Mittelwert und/oder eine Standardabweichung ermittelt wird.

8. Verfahren nach einem der Ansprüche 1 bis 7, **dadurch gekennzeichnet, dass** die Strom- und/oder Spannungsverläufe an im Wesentlichen einem Punkt der elektrischen Installationsanlage aufgenommen werden.

9. Verfahren nach einem der Ansprüche 1 bis 8, **dadurch gekennzeichnet, dass** mit den Charakteristika, insbesondere mit einem Mittelwert einer vorgebbaren Anzahl aufgenommener Strom- und/oder Spannungsverläufe, ein adaptives Filter eingestellt wird.

10. Verfahren nach einem der Ansprüche 1 bis 9, **dadurch gekennzeichnet, dass** Gruppen unterschiedlicher Charakteristika, insbesondere Gruppen von Mittelwerten von Charakteristika, in einer Bibliothek gespeichert werden.

11. Verfahren nach einem der Ansprüche 1 bis 10, **dadurch gekennzeichnet, dass** wenigstens ein Charakteristikum in wenigstens einen ersten mathematischen Algorithmus aufgenommen wird.

12. Verfahren zum Schutz einer elektrischen Installationsanlage vor Lichtbögen, wobei wenigstens ein elektrischer Strom- und/oder Spannungsverlauf aufgenommen wird, welcher nachfolgend mit wenigstens einem, nach einem Verfahren nach einem der Ansprüche 1 bis 10 ermittelten Charakteristikum verglichen oder einem Algorithmus nach Anspruch 11 bewertet wird, wobei bei einer vorgebbaren Annäherung wenigstens einer Eigenschaft des ermittelten Strom- und/oder Spannungsverlaufs mit dem wenigstens einen ermittelten Charakteristikum oder einem vorgebbaren Grenzwert wenigstens ein Teil der elektrischen Installationsanlage abgeschaltet wird.

13. Verfahren nach Anspruch 12, **dadurch gekennzeichnet, dass** das Charakteristikum oder der Algorithmus aus einer vorgebbaren Anzahl gespeicherter Charakteristika bzw. Algorithmen vorgebbar ausgewählt wird.

14. Verfahren nach Anspruch 13, **dadurch gekennzeichnet, dass** zur Auswahl des Charakteristikums oder des Algorithmus die Anzahl der auftretenden bzw. ausgefallenen Halbwellen festgestellt wird.

15. Verfahren nach Anspruch 13 oder 14, **dadurch gekennzeichnet, dass** zur Auswahl des Charakteristikums oder des Algorithmus eine erste Amplitude in einem ersten Frequenzband, und eine zweite Amplitude in einem zweiten Frequenzband festgestellt wird, dass die erste Amplitude mit der zweiten Amplitude verglichen wird.

16. Verfahren nach Anspruch 13, 14 oder 15, **dadurch gekennzeichnet, dass** zur Auswahl des Charakteristikums oder des Algorithmus eine Phasenverschiebung zwischen einem Stromverlauf und einem Spannungsverlauf festgestellt wird.

17. Lichtbogenschutzschalter (36) mit wenigstens einem Stromsensor und/oder wenigstens einem Spannungssensor zur Aufnahme eines Strom- bzw. Spannungsverlaufes, sowie mit Schaltkontakten (37) zur vorgebbaren Unterbrechung einer elektrischen Verbindung innerhalb einer elektrischen Installationsanlage, **dadurch gekennzeichnet, dass** der Lichtbogenschutzschalter (36) eine elektrische Schaltungsanordnung, umfassend einen Mikrokontroller, zur Durchführung eines Verfahrens nach einem der Ansprüche 1 bis 11 und/oder einem Verfahren nach einem der Ansprüche 12 bis 16 aufweist, und die Schaltungsanordnung wenigstens mittelbar mit den Schaltkontakten (37) wirkverbunden ist.

## Claims

1. Method for directly adapting and/or training an electric arc sensor (35) in relation to the effects of different electric arcs which occur in an electrical installation system which is to be protected and/or monitored, whereby a predeterminable number of predeterminable electric arcs are simulated and/or generated at least at a first position in the installation system, whereby following each simulated or generated electric arc at least one current curve and/or voltage curve is recorded, whereby at least one characteristic of the recorded current curves and/or voltage curves is determined and/or stored, **characterised in that** a number of failed half-waves of the current curve and/or voltage curve is determined and/or stored as at least one characteristic.

2. Method according to claim 1, **characterised in that** the recorded current curves and/or voltage curves are analysed in a predeterminable manner in a time range and/or an image range, in particular a frequency range, for determination of the at least one characteristic.

3. Method according to claim 1 or 2, **characterised in that** at least one predeterminable part of a time curve and/or an envelope curve of the time curve of the current curve and/or voltage curve is determined and/or stored as at least one characteristic.

4. Method according to claim 1 to 3, **characterised in that** at least one predeterminable part of a frequency spectrum and/or an envelope curve of the frequency spectrum of the current curve and/or voltage curve is determined and/or stored as at least one characteristic.

5. Method according to any of claims 1 to 4, **characterised in that** an amplitude value in a predeterminable frequency band is determined and/or stored as at least one characteristic.

6. Method according to any of claims 1 to 5, **characterised in that** a phase shift of the current curve and/or voltage curve is determined and/or stored as at least one characteristic.

7. Method according to any of claims 1 to 6, **characterised in that** a mean value and/or a standard deviation are determined from a predeterminable number of determined characteristics.

8. Method according to any of claims 1 to 7, **characterised in that** the current curves and/or voltage curves are recorded at substantially one point of the electrical installation system.

9. Method according to any of claims 1 to 8, **characterised in that** an adaptive filter is set with the characteristic, in particular with a mean value of a predeterminable number of recorded current curves and/or voltage curves.

10. Method according to any of claims 1 to 9, **characterised in that** groups of different characteristics, in particular groups of mean values of characteristics, are stored in a library.

11. Method according to any of claims 1 to 10, **characterised in that** at least one characteristic is recorded in at least one first mathematical algorithm.

12. Method for protecting an electric installation system against electric arcs, whereby at least one electric current curve and/or voltage curve is recorded, which is subsequently compared with at least one characteristic determined by a method according to a method according to any of claims 1 to 10 or is evaluated with an algorithm according to claim 11, whereby in the event of a predeterminable convergence of at least one property of the determined current curve and/or voltage curve with the at least one determined characteristic or a predeterminable limit value, at least a part pf the electrical installation system is switched off.

13. Method according to claim 12, **characterised in that** the characteristic or the algorithm is selected in a predeterminable manner from a predeterminable number of stored characteristics or algorithms.

14. Method according to claim 13, **characterised in that** in order to select the characteristic or the algorithm the number of half-waves which occur or which fail is ascertained.

15. Method according to claim 13 or 14, **characterised in that** in order to select the characteristic or the algorithm a first amplitude in a first frequency band and a second amplitude in a second frequency band are ascertained, and that the first amplitude is compared with the second amplitude.

16. Method according to claim 13, 14 or 15, **characterised in that** in order to select the characteristic or the algorithm a phase shift between a current curve and a voltage curve is ascertained.

17. Electric arc circuit breaker (36) having at least one current sensor and/or at least one voltage sensor to record a current curve or voltage curve, and also having switch contacts (37) for predeterminable interruption of an electrical connection within an electrical installation system, **characterised in that** the electric arc circuit breaker (36) has an electrical circuit arrangement, comprising a microcontroller, for carrying out a method according to any of claims 1 to 11, and/or a method according to any of claims 12 to 16, the circuit arrangement is operatively connected at least indirectly to the switching contacts (37).

## Revendications

1. Procédé pour l'adaptation et/ou pour l'apprentissage d'un détecteur d'arc électrique (35) directement dans une installation électrique à protéger et/ou à surveiller quant aux effets de divers arcs électriques se produisant, dans lequel un nombre pouvant être préétabli d'arcs électriques pouvant être préétablis sont simulés et/ou produits au moins en une première position dans l'installation électrique, dans lequel au moins une courbe d'intensité et/ou de tension est enregistrée à la suite de chaque arc électrique simulé ou produit, dans lequel au moins une caractéristique des courbes d'intensité et/ou de tension enregistrées est déterminée et/ou mémorisée, **caractérisé en ce qu'**en tant qu'au moins une caractéristique, un nombre de demi-ondes absentes de la courbe d'intensité et/ou de tension est déterminé et/ou mémorisé.

2. Procédé selon la revendication 1, **caractérisé en ce que** les courbes d'intensité et/ou de tension enregistrées sont analysées de façon pouvant être préétablie dans un espace de temps et/ou un espace d'image, en particulier une gamme de fréquences, pour la détermination de l'au moins une caractéristique.

3. Procédé selon la revendication 1 ou 2, **caractérisé en ce qu'**en tant qu'au moins une caractéristique, au moins une partie pouvant être préétablie d'une courbe de temps et/ou d'une enveloppe de la courbe de temps de la courbe d'intensité et/ou de tension est déterminée et/ou mémorisée.

4. Procédé selon l'une quelconque des revendications 1 à 3, **caractérisé en ce qu'**en tant qu'au moins une caractéristique, au moins une partie pouvant être préétablie d'un spectre de fréquence et/ou une enveloppe de la courbe du spectre de fréquence de la courbe d'intensité et/ou de tension est déterminée et/ou mémorisée.

5. Procédé selon l'une quelconque des revendications 1 à 4, **caractérisé en ce qu'**en tant qu'au moins une caractéristique, une valeur d'amplitude dans une bande de fréquence pouvant être préétablie est déterminée et/ou mémorisée.

6. Procédé selon l'une quelconque des revendications 1 à 5, **caractérisé en ce qu'**en tant qu'au moins une caractéristique, un déphasage de la courbe d'intensité et/ou de tension est déterminé et/ou mémorisé

7. Procédé selon l'une quelconque des revendications 1 à 6, **caractérisé en ce qu'**une valeur moyenne et/ou un écart type est déterminé(e) à partir d'un nombre pouvant être préétabli de caractéristiques déterminées.

8. Procédé selon l'une quelconque des revendications 1 à 7, **caractérisé en ce que** les courbes d'intensité et/ou de tension sont enregistrées sensiblement au niveau d'un point de l'installation électrique.

9. Procédé selon l'une quelconque des revendications 1 à 8, **caractérisé en ce qu'**avec les caractéristiques, en particulier avec une valeur moyenne d'un nombre pouvant être préétabli de courbes d'intensité et/ou de tension enregistrées, un filtre d'adaptation est ajusté.

10. Procédé selon l'une quelconque des revendications 1 à 9, **caractérisé en ce que** des groupes de différentes caractéristiques, en particulier des groupes de valeurs moyennes de caractéristiques, sont mémorisés dans une bibliothèque.

11. Procédé selon l'une quelconque des revendications 1 à 10, **caractérisé en ce qu'**au moins une caractéristique est enregistrée dans au moins un premier algorithme mathématique.

12. Procédé pour la protection d'une installation électrique contre des arcs électriques, dans lequel est enregistrée au moins une courbe d'intensité et/ou de tension électrique qui est ensuite comparée à au moins une caractéristique déterminée conformément à un procédé selon l'une quelconque des revendications 1 à 10 ou évaluée par un algorithme selon la revendication 11, dans lequel en cas d'un rapprochement pouvant être préétabli d'au moins une propriété de la courbe d'intensité et/ou de tension déterminée, avec l'au moins une caractéristique déterminée ou une valeur limite pouvant être préétablie, au moins une partie de l'installation électrique est mise hors circuit.

13. Procédé selon la revendication 12, **caractérisé en ce que** la caractéristique ou l'algorithme est choisi(e) de façon pouvant être préétablie parmi un nombre pouvant être préétabli de caractéristiques ou respectivement d'algorithmes mémorisé(e)s.

14. Procédé selon la revendication 13, **caractérisé en ce que**, pour le choix de la caractéristique ou de l'algorithme, on fixe le nombre des demi-ondes apparaissant ou respectivement absentes.

15. Procédé selon la revendication 13 ou 14, **caractérisé en ce que**, pour le choix de la caractéristique ou de l'algorithme, on fixe une première amplitude dans une première bande de fréquence et une seconde amplitude dans une seconde bande de fréquence, de façon à comparer la première amplitude à la seconde amplitude.

16. Procédé selon la revendication 13, 14 ou 15, **caractérisé en ce que**, pour le choix de la caractéristique ou de l'algorithme, on fixe un déphasage entre une courbe de courant et une courbe de tension.

17. Disjoncteur de protection contre les arcs électriques (36) avec au moins un détecteur de courant et/ou au moins un détecteur de tension destiné(s) à la capture d'une courbe de courant ou respectivement de tension, ainsi que des contacts de commutation (37) destinés à l'interruption pouvant être préétablie d'une connexion électrique à l'intérieur d'une installation électrique, **caractérisé en ce que** le disjoncteur de protection contre les arcs électriques (36) présente un dispositif de commutation électrique, comprenant un microcontrôleur, destiné à l'exécution d'un procédé selon l'une quelconque des revendications 1 à 11 et/ou d'un procédé selon l'une quelconque des revendications 12 à 16, et le dispositif de commutation est fonctionnellement lié au moins directement aux contacts de commutation (37).
